(19) Europäisches Patentamt
European Patent Office
Office européen des brevets

(11) **EP 2 829 994 A2**

(12) **EUROPEAN PATENT APPLICATION**

(43) Date of publication:
**28.01.2015 Bulletin 2015/05**

(51) Int Cl.:
**G06F 17/50** (2006.01)    **G06T 17/20** (2006.01)

(21) Application number: **14158159.5**

(22) Date of filing: **06.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.03.2013 US 201313833996**

(71) Applicant: **AIRBUS OPERATIONS (S.A.S)**
**31060 Toulouse (FR)**

(72) Inventors:
• **Grellou, Olivier**
  **82370 Villebrumier (FR)**

• **Van Der Veen, Sjoerd**
  **31170 Tournefeuille (FR)**
• **Justine, Kenny**
  **97100 Basse-Terre (FR)**

(74) Representative: **Gicquel, Olivier Yves Gérard**
**Airbus Opérations (S.A.S.)**
**Intellectual Property Department**
**316, route de Bayonne**
**ETRT - M0101/1**
**31060 Toulouse (FR)**

(54) **Method for coupling non-destructive inspection data for a material or structure to an analysis tool**

(57)    A computer aided method (10) is provided for coupling non-destructive inspection data for a material or structure to an analysis tool. The method includes receiving a voxel data (34, 36) representation of a damaged area of the material or structure, and generating a finite element mesh (28) based on the voxel data representation. The finite element mesh (20) includes a plurality of nodes, each node corresponding to one or more voxels of the voxel data representation. The method further includes integrating damage information from the voxel data representation into the finite element mesh by applying at least one integration rule (22), the damage information indicating whether or not a given voxel has sustained damage. Damage information for areas of the finite element mesh that does not include damage information is interpolated by applying at least one interpolation rule (26). A finite element model (28) including a finite element mesh having damage information associated therewith is output.

Fig. 1

**EP 2 829 994 A2**

**Description**

A field of the invention is non-destructive testing. A particular application of the invention is to non-destructive testing of structures and materials used in aircraft. The invention is useful, for example, during assembly of new aircraft and for inspection of aircraft as part of an inspection, service and maintenance schedule.

Non-destructive inspection (NDI) of a material or structure involves thoroughly examining the material or structure without harming or requiring significant disassembly thereof. Non-destructive inspection is advantageous for many applications in which a thorough inspection of the exterior and/or interior of a material or structure is required. For example, non-destructive investigation is commonly utilized in the aircraft industry to inspect structures and/or materials used in an aircraft for any type of internal or external damage. Such inspection may be performed, for example, at the time of manufacture, and periodically throughout the useful life of the aircraft. For example, metals and/or metallic aircraft structures are typically inspected for corrosion and/or cracking, particularly near fasteners. Composite materials and/or structures are typically inspected for any type of damage, such as delamination, occurring anywhere on or within the composite material.

Common NDI data acquisition methods include ultrasonic, magnetic-particle, liquid penetrant, radiographic, remote visual inspection, eddy-current testing, and low coherence interferometry. Various sensors can be used to obtain non-destructive inspection data. One or more sensors may move over the material or structure to be examined, and receive data regarding the material or structure. For example, ultrasonic testing could be used to generate a sound wave through a sensor or probe that is directed towards a part. When there is a flaw in the part, the sound wave will reflect back from the flaw and the flaw can therefore be detected. A pulse-echo sensor may be used to obtain ultrasonic data, such as thickness gauging, detection of laminar defects and porosity, and/or crack detection in the material or structure. Resonance, pitch/catch or mechanical impedance sensors may be used to provide indications of voids or porosity, such as in adhesive bonds of the material or structure. In addition, eddy current probes, using electromagnetic induction to impart and detect eddy currents within a material or structure to identify cracks and/or corrosion may also be used, particularly in metallic or other conductive materials or structures.

Various NDI inspection processes and tools are used to map defects in a structure, but it remains difficult to determine what effect the discovered defects would have on the usefulness of the structure. For this reason, when defects are discovered in a material or structure, the defective material or structure is typically either repaired or discarded. This leads to increased build costs and maintenance costs due to waste of potentially service-worthy materials and structural components and/or the conducting of unneeded repairs.

Tools exist to evaluate performance characteristics of solid materials and structures. Computer aided engineering (CAE) uses, for example, finite element analysis of a structure to determine performance characteristics of materials and structures. CAE relies on computer modeling and analysis of mechanical components and assemblies and visualizing the finite element analysis result. Evaluation of a defect with CAE requires significant human interaction to develop a suitable model for evaluation. This causes construction of a model suitable for use with a finite element analysis/CAE system to be labor intensive, and thus costly. Moreover, because each model must be specific to the discovered defect, there is limited opportunity for re-use of the model after its creation.

Additionally, because of the difficulty in inspecting structures by hand, simulation tools exist to verify the inspectability of a structure as a part of the design process. CAE can be used to simulate a process or event that leads to a defect or damage (e.g., manufacturing defect, impact, etc.).

Simulated non-destructive investigation, allows a user to determine if the structure will be inspectable to the degree necessary to successfully identify the simulated defect or damage. Additionally, the simulated NDI serves as a training tool, allowing users to see how particular defects manifest in an inspection of the structure. However, generating a dedicated inspection simulation model by hand based on the results of the CAE analysis is too time consuming (and too costly) to allow for systematic application of inspectability analyses.

In a first aspect, a method is provided for coupling non-destructive inspection data for a material or structure to an analysis tool. The method includes receiving a voxel data representation of a damaged area of the material or structure, and generating a finite element mesh based on the voxel data representation. The finite element mesh includes a plurality of nodes, each node corresponding to one or more voxels of the voxel data representation. The method further includes integrating damage information from the voxel data representation into the finite element mesh by applying at least one integration rule, the damage information indicating whether or not a given voxel has sustained damage. Damage information for areas of the finite element mesh that do not include damage information is interpolated by applying at least one interpolation rule. A finite element model including a finite element mesh having damage information associated therewith is output.

In another aspect, a method is provided for coupling damage simulation for a material or structure data to a non-destructive inspection simulation tool. The method includes receiving simulation data related to an event which caused damage to the material or structure, and generating one or more contour maps corresponding to damaged areas of the material or structure. The simulation data is aggregated with the one or more contour maps by applying at least one aggregation rule, and data is interpolated in the contour maps after said aggregating by applying one or more interpolation rules. A voxel model of the structure including the damaged area based on said interpolated contour maps is output.

Further features and advantages will become apparent from the description of the invention which follows, which description is given purely by way of example with reference to the attached drawings in which:

FIG. 1 is a schematic diagram illustrating a process for coupling output of a non-destructive inspection to a finite element analysis using computer aided engineering according to an embodiment of the present invention;

FIG. 2 is an example representation of voxel data generated by a Time-Domain Topological Energy reconstruction;

FIG. 3 is a sample of a graphical representation of a Finite Element Mesh showing several plies and interplies;

FIG. 4A is a visual representation of an specimen model, showing plies and interplies thereof;

FIG 4B is a perspective view of one interply of the specimen model of FIG. 4A;

FIG 5A is a top view of the specimen model of FIG 4A;

FIG 5B is a bottom view of the specimen model of FIG 4A;

FIG. 6 is a schematic diagram illustrating a process for coupling output of a simulation of an event leading to defects or damage to a simulated non-destructive inspection according to an embodiment of the present invention; and

FIG. 7 is a sample contour map showing defects and/or damage to a material or structure based on an event simulation.

Present day aircraft benefit greatly from the use of composite materials in their construction. Composite materials maximize weight reduction, with many composite materials being up to 20% lighter than aluminum. Moreover, composite materials are known to be more reliable than other traditional metallic materials, leading to reduced aircraft maintenance costs, and a lower number of inspections during service. Additional benefits of composite technologies include added strength and superior durability for a longer lifespan. Still further, composites are generally corrosion-free, which lessens the quantity of chemicals necessary to protect structural components. The weight reductions from composites also result in lower fuel consumption during an aircraft's operational lifetime.

In addition to in-service inspection requirements, both metallic and composite materials are evaluated during the manufacturing process through non-destructive inspection (NDI) to guarantee "defect-free" qualities. NDI may be performed using, for example, a computer running a software program such as CIVA. There are individual operational advantages to both composites and metallics in construction of an airframe or other structure. Accordingly, an overall airframe typically features an optimum balance of both materials. Thus, it is important that tools exist for inspection of both metallics and composites.

Materials undergo a comprehensive NDI to determine whether the material includes any defect or damage. Inspections take place after manufacturing, and intermittently throughout the life span of the material. The inspection may include, for example, an ultrasound (or ultrasonic) inspection. In such an inspection, an ultrasound transducer connected to a diagnostic machine is passed over the object being inspected. The transducer preferably performs both sending and receiving of pulsed waves having frequencies ranging from 0.1-15 MHz and occasionally up to 50 MHz as the ultrasonic signal is reflected back to the device. The reflected signal comes from an interface, such as the back wall of the object or from an imperfection within the object. The diagnostic machine records and, preferably, displays these results in the form of a signal with an amplitude representing the intensity of the reflection and the distance, representing the arrival time of the reflection. Ultrasonic inspection advantageously allows for testing of the entire material, even when only one surface of the material is accessible.

Embodiments of the invention provide a coupling tool for coupling results of non-destructive inspection with computer aided engineering, and conversely coupling computer aided engineering with a simulation of non-destructive inspection. In particular, embodiments of the invention relate to a coupling tool for coupling results of inspection data and computer aided engineering for testing of structures and materials used in aircraft.

Those knowledgeable in the art will appreciate that embodiments of the present invention lend themselves well to practice in the form of computer program products. Accordingly, it will be appreciated that embodiments of the present invention may comprise computer program products comprising computer executable instructions stored on a non-transitory computer readable medium that, when executed, cause a computer to undertake methods according to the present invention, or a computer configured to carry out such methods. The executable instructions may comprise computer program language instructions that have been compiled into a machine-readable format. The non-transitory computer-readable medium may comprise, by way of example, a magnetic, optical, signal-based, and/or circuitry medium useful for storing data. The instructions may be downloaded entirely or in part from a networked computer. Also, it will be appreciated that the term "computer" as used herein is intended to broadly refer to any machine capable of reading and executing recorded instructions. It will also be understood that results of methods of the present invention may be displayed on one or more monitors or displays (e.g., as text, graphics, charts, code, etc.), printed on suitable media, stored in appropriate memory or storage, etc.

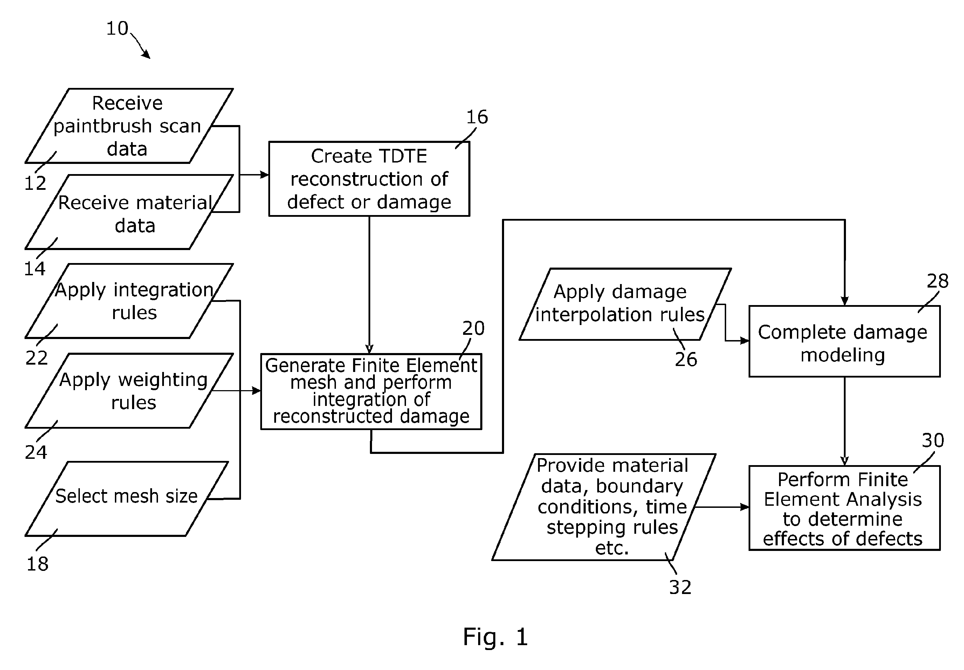

Referring now to FIG. 1, a method of coupling output of a non-destructive inspection to a finite element analysis is generally designated 10. Scan data from the NDI is received at step 12. As indicated in FIG. 1, the received scan data is preferably from a paintbrush-type ultrasound scan, although other NDI methods may be used without departing from the scope of the present invention.

In step 14, material data is received. Interpreting the results of the ultrasound inspection requires knowledge of the physical properties of the material being inspected. As a non-limiting example, knowledge of the speed at which sound travels through the material being tested is instrumental in determining the depth of any flaw discovered using the ultrasound testing. If material properties are not available, a preliminary step can be conducted to characterize a material. Such a preliminary step could be used, for example, when employing a new or modified composite in a structure.

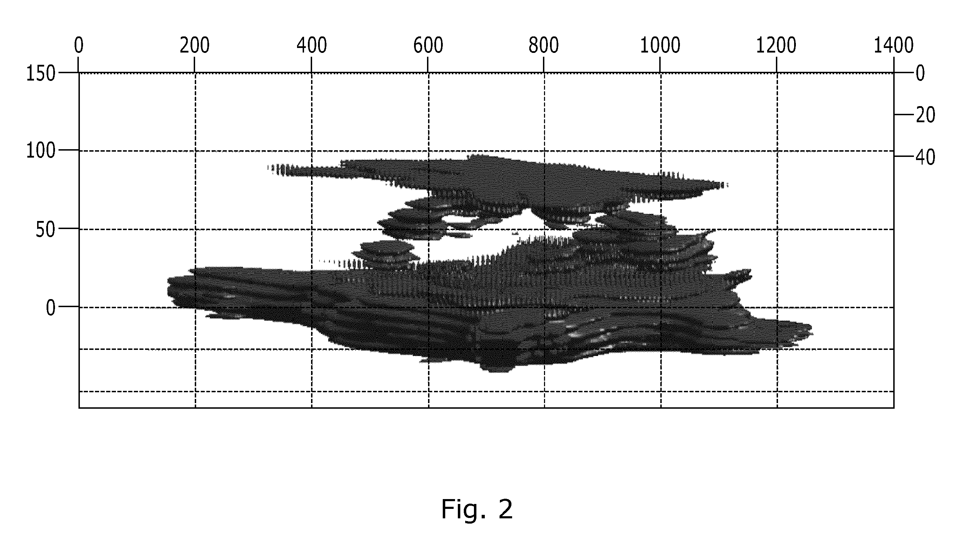

The acquired NDI scan data and the material data is processed using a Time Domain Topological Energy (TDTE) reconstruction algorithm to create a TDTE model of the defect or damage to the material being tested in step 16. The TDTE model facilitates interfacing the NDI scan data and material data with a computer aided engineering tool. In particular, the TDTE reconstruction algorithm creates a cloud of voxels representing a damaged area of the structure material, surrounded by a volume of intact material. Each voxel represents a single sample, or data point, on a regularly spaced three dimensional grid. In particular, the TDTE algorithm takes time domain data collected by the ultrasound inspection (i.e., how long it takes for echoes to return to the transducer) and converts that data into a topological model of the area containing the defect. As shown in FIG. 2, a model created using the TDTE reconstruction algorithm includes a cloud of voxels representing damaged material 34 surrounded by a volume of intact material 3 6.

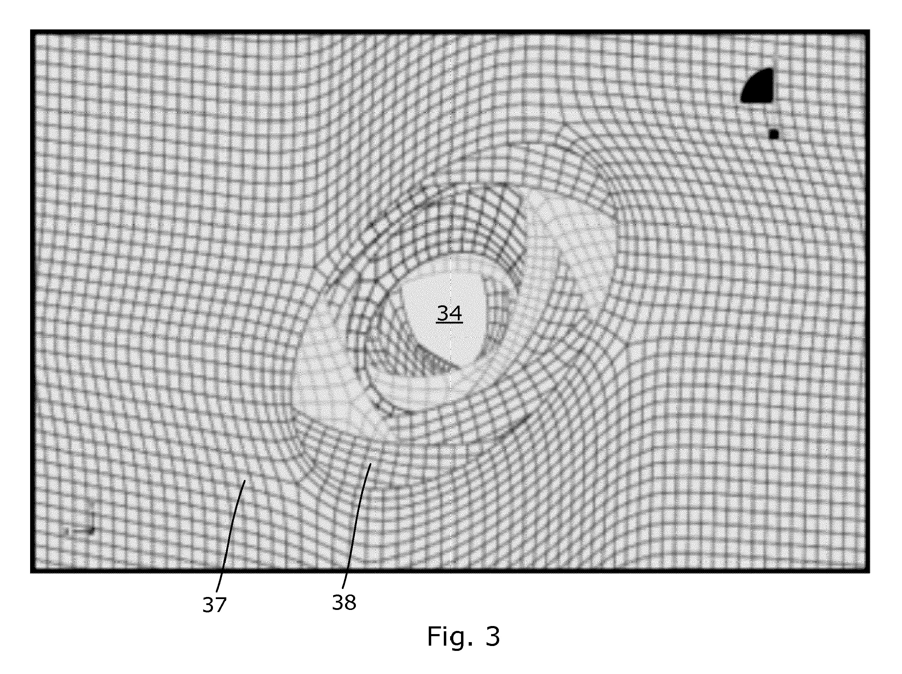

Referring again to FIG. 1, after generating the voxel model using the TDTE reconstruction, the model serves as the basis for generating a finite element mesh. FIG 3 shows an example finite element mesh, including multiple plies 37 and interplies 38, with a material defect 34 extending through the plies and interplies of the mesh. Typically, the resolution of the TDTE reconstruction of the material or structure is richer than is necessary or desirable for a computer aided engineering analysis of the material or structure. Accordingly, resolution of the finite element mesh generated is set to have the same or less resolution than the voxel model created in the TDTE reconstruction in step 18.

A preferred embodiment coupling tool of the invention receives TDTE data and generates a finite element mesh corresponding to the material or structure from the voxel data in step 20. The finite element mesh is created by applying integration rules in step 22 and weighting rules in step 24. Regions of the mesh corresponding to areas of the structure or material which will receive large amounts of stress usually typically have a higher node density than those which experience little or no stress. The mesh is structured like a web in that from each node, there extends a mesh element connecting each of the adjacent nodes. This mesh object is preferably programmed with the material or structure properties.

The finite element mesh is preferably modeled either such that the interply is modeled with discrete elements, or such that the interply is modeled without thickness using, for example, disconnected nodes or cohesive zone elements.

In case of discrete interply, one way to construct the mesh is to take the ply and interply thickness information input by the user and determine how many voxels fit in that thickness. The number of voxels is compared to a desired element count, and the voxels are grouped together into element nodes based on this comparison. As an example, voxels can be grouped into nodes in multiples of 8, because 8 small cubic voxels make up 1 larger cube with twice the side length. Corner nodes of such an element will also be corners of the group of voxels.

Where the interply is modeled as if it had no thickness, it is customary to add half of the real thickness of the interply to the ply directly above the interply, and half to the ply directly below. The volumes of each ply are then meshed by grouping voxels together to form elements as discussed above. The damaged interply is accounted for by, for example, leaving nodes between plies unattached (resulting in nodes at ply interfaces lying on top of each other without being connected). Undamaged interply portions are represented by nodes that are attached as usual in a finite element mesh. Another exemplary way to represent damaged interply nodes is using zero-thickness cohesive zone elements. When such elements are used, damaged interply portions are preferably represented with unconnected nodes as above, whereas undamaged interply are modeled by coupling the ply above to the top of the cohesive zone element and the ply below to the bottom of the cohesive zone element. The plies are thus connected only through the cohesive zone elements

To create the mesh, the voxel data is divided into plies and interplies having thicknesses such that relatively thick plies are separated by thinner interplies. Preferably, the thicknesses and orientations of each of the plies and interplies are predetermined, for example by input from an operator. The minimum thickness for an interply is selected such that each interply thickness is represented by at least one voxel. Voxel data corresponding to a center portion of each ply and interply will be analyzed. The integration rules are applied to the finite element mesh in step 22 to populate the mesh with information. In a first preferred integration rule, a slice through the voxel data at the center of each ply and each interply is taken. For any voxel showing damage in a ply, the corresponding portion of the finite element mesh is deleted or marked as damaged. For interplies, the mesh may be deleted or marked as damaged when the structure or material is modeled using continuous elements, or simply disconnected if the structure or material is modeled using discrete elements.

In a second preferred integration rule, a slice is taken through the center of each interply. For any voxel showing damage, a damage value is assigned to that interply element. Damage to the plies is also evaluated and applied to the interply elements the final damage status of the interply element ($DD_i$) is calculated based on damage status of the interply ($DD_{interply}$), damage status of the ply directly above the interply ($DD_{ply\_above}$), and damage status of the ply directly below the interply ($DD_{ply\_below}$) according to any one of equations 1-4 below:

$$(\text{equation 1}) \qquad DD_i = (DD_{interply} + DD_{ply\_above} + DD_{ply\_below})/3$$

$$(\text{equation 2}) \; DD_i = (w_1 * DD_{interply} + w_2 * DD_{ply\_above} + w_3 * DD_{ply\_below})/3,$$

wher $w_1$, $w_2$, and $w_3$ are predefined weighting factors.

$$(\text{equation 3}) \; DD_i = \max(DD_{interply}, DD_{ply\_above}, DD_{ply\_below})$$

$$(\text{equation 4}) \; DD_i = \max(w_1 * DD_{interply}, w_2 * DD_{ply\_above}, w_3 * DD_{ply\_below}),$$

where $w_1$, $w_2$, and $w_3$ are predefined weighting factors.

After selecting one of the equations 1-4, if the final interply damage status $DD_i$ is 1, the surrounding interply elements are deleted or marked as damaged when the structure or material is modeled using continuous elements. If the structure or material is modeled using discrete elements, ply elements directly adjacent (i.e., directly above and below) the damaged portion of the interply are disconnected.

As a third and most preferred integration rule, ply layers are analyzed first. For any voxel showing damage, a damage value is assigned to that ply element. Thereafter, damage to the interplies is evaluated and applied to the ply elements the final damage status of the ply element ($DD_p$) is calculated based on damage status of the ply ($DD_{ply}$), damage status of the interply directly above the interply ($DD_{interply\_above}$), and damage status of the ply directly below the interply ($DD_{interply\_below}$) according to any one of equations 5-8 below:

$$(\text{equation 5}) \qquad DD_p = (DD_{ply} + DD_{interply\_above} + DD_{interply\_below})/3$$

$$(\text{equation 6}) \; DD_p = (w_1 * DD_{ply} + w_2 * DD_{interply\_above} + w_3 * DD_{interply\_below})/3,$$

where $w_1$, $w_2$, and $w_3$ are predefined weighting factors.

$$(\text{equation 7}) \; DD_p = \max(DD_{ply}, DD_{interply\_above}, DD_{interply\_below})$$

$$(\text{equation 8}) \; DD_p = \max(w_1 * DD_{ply}, w_2 * DD_{interply\_above}, w_3 * DD_{interply\_below}),$$

where $w_1$, $w_2$, and $w_3$ are predefined weighting factors

If the final damage status of the ply element ($DD_p$) is 1 based on the selected equation, the ply element is deleted or marked as damaged.

Moreover, as described in equations 2, 4, 6, and 8 above, weighting factors are optionally applied to the damage status values in step 24. Thus, the voxel cloud, the integration rules, and the predetermined weighting factors are combined to produce the finite element mesh of a size selected by a user. The finite element mesh includes all damage marked in the voxel cloud.

Moreover, the voxel representation resulting from the TDTE reconstruction may include "holes," where the damage status of the voxels is unknown. These holes occur, for example, due to shadows during acquisition of the ultrasound data. Typically, the holes are surrounded by voxels for which the damage status is clear. To fill the holes, interpolation rules are applied to the finite element mesh in step 26. A first preferred interpolation rule is to scan each horizontal and vertical line of voxels on each layer, and when one or more voxels of unknown damage status are determined to exist between two damaged voxels, the status of each unknown voxel is set to "damaged." Alternatively, a second preferred interpolation rule is, for each slice, a contour such as an ellipse or a spline surrounding all damaged voxels is fitted within the slice. Any voxel within the perimeter of the contour is marked as "damaged." One of the interpolation rules is preferably selected by an operator

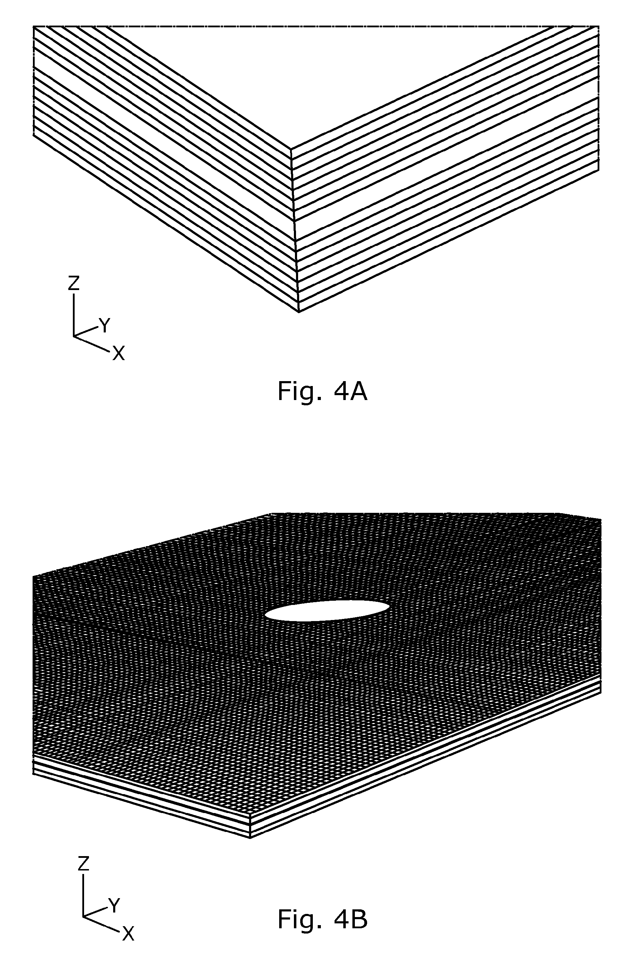

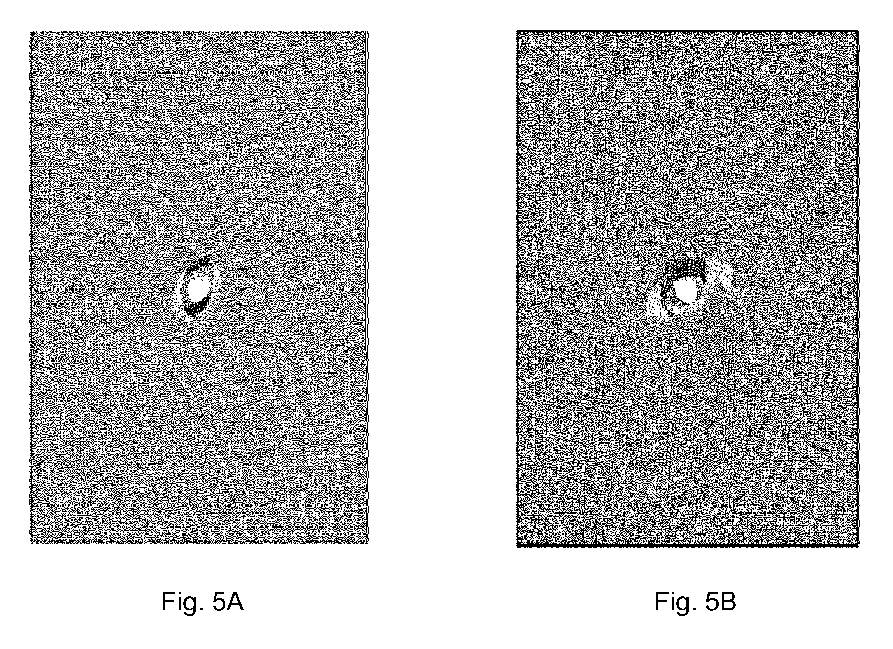

Once the selected interpolation rule has been applied, the damage modeling is completed in step 28, and a finite element model is output. FIGs. 4A-and 4B show views of a completed example specimen model. In particular, FIG. 4A shows multiple plies and interplies that form a composite material. FIG. 4B shows a material defect located centrally in the model. FIGS. 5A and 5B show top and bottom views, respectively, of the interplies included in the specimen model. This model can be coupled into a conventional finite element analysis in step 30 to determine effects of defects in the model output. Additional information, including material data, boundary conditions, time stepping rules, and the like are provided to the finite element analysis in step 32, and the finite element model may then be used, alongside the additional provided information to perform finite element analysis to determine the effects of the defects or damage contained within the material. In particular, existing damage and failure analyses can be used to determine effects of the defects incorporated in the material or structure. Finite element analysis is preferably performed using a computer executing a computer aided engineering program such as ABAQUS.

Another focus of the present coupling tool is to improve inspectability by allowing for simulation of non-destructive inspection. Aircraft parts are often difficult to inspect, and while simulation tools exist to verify inspectability early in design, generation of dedicated inspection simulation models is too time consuming and costly to systematically apply the inspectability analysis to all materials and structures. Defects and damage to a structure may be caused by an event such as an impact or collision, or by an error in manufacturing. By simulating the physics causing defects and/or damage to a material or structure, it is possible to obtain an objective description of the defect and/or damage without need for human intervention.

Required physics-based models for testing the material or structure generally exist already. Regarding the examples discussed above, impact models are used to check vulnerabilities of current designs, and to certify particular structures and materials with respect to the vulnerability (e.g., certifying a structure to withstand impacts up to a predetermined force); manufacturing process simulations are used to optimize tooling a processing conditions for machining materials or structures. Accordingly, existing simulation processes are sufficient for modeling needs.

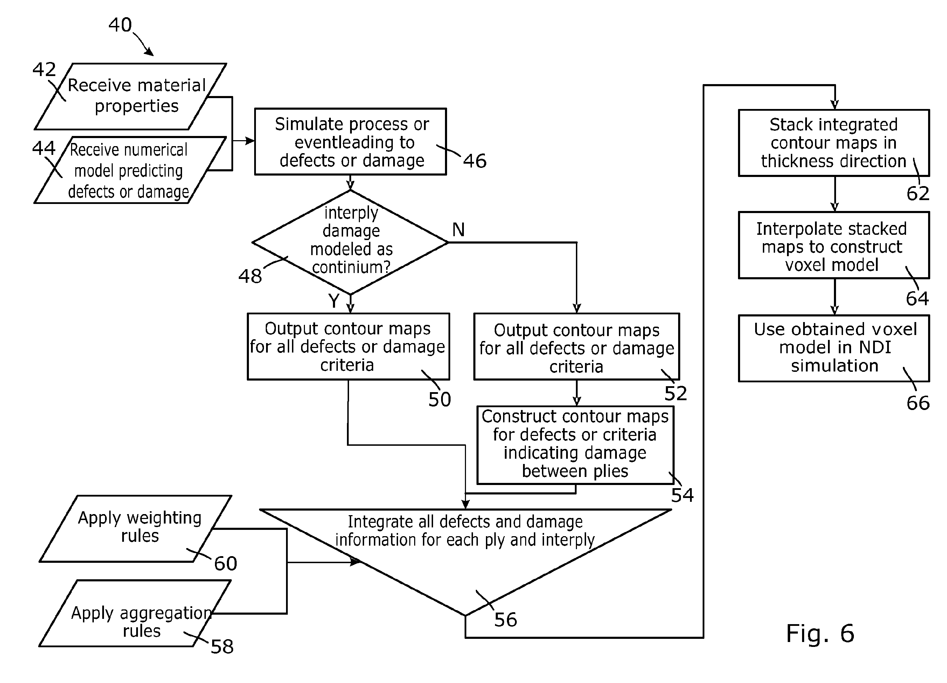

Referring now to FIG. 6, a process for coupling output of a simulation of an event leading to defects or damage to a simulated non-destructive inspection is generally labeled 40. This process is essentially a converse of the process of FIG. 1. Properties of the material that has been the subject of the event causing defect or damage is received in step 42. A numerical model predicting the defect or damage caused by the event is received in step 44. Based on the received material data and numerical model, the event is simulated in step 46.

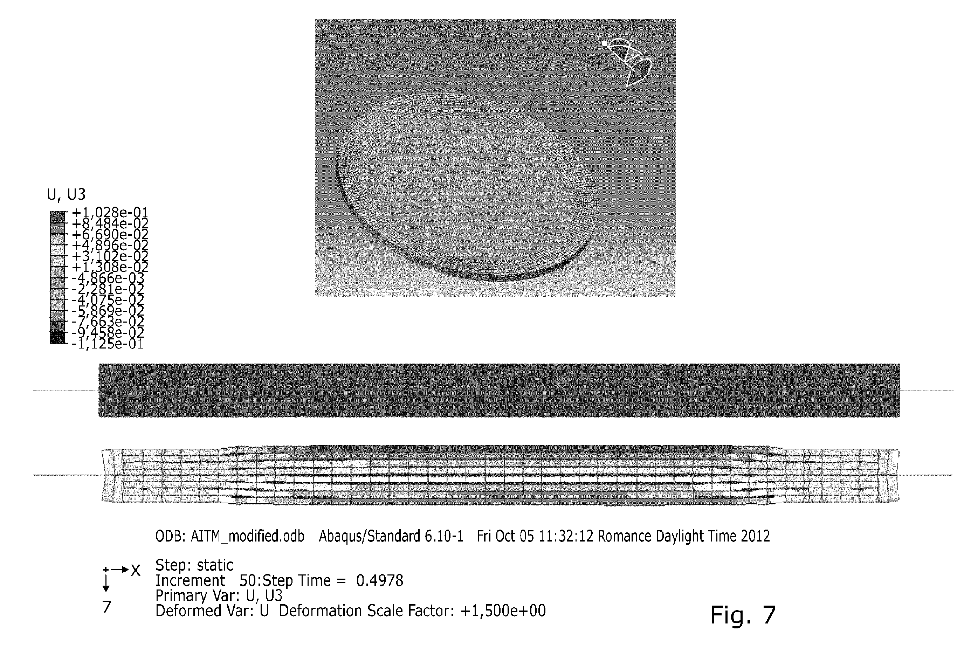

It is determined whether the material or structure has been modeled as a continuum or discretely in step 48. If the material or device is modeled as a continuum (Y in step 48), for each ply and interply in the model, contour maps of all defects and damage are output in step 50. A sample contour map is shown in FIG. 7. The maps are preferably output in a human-readable format, such as a bitmap. In addition to the contour maps, a position and thickness associated with each of the maps is also exported.

Alternatively, if the material or device is modeled discretely (N in step 48), for each ply in the model, contours of all defect and damage are output in step 52, preferably in a human-readable format such as a bitmap. Moreover, position and thickness of each ply are output, as discussed above. Further, if cohesive elements or fracture mechanics techniques (e.g., Virtual Crack Closure Technique) are used, damage contour maps between the plies similar to those required for interply damage are created and output in optional step 54. Position and thickness for these contour maps is also output. To aid users, a default thickness of 0.0125 mm is suggested, but this value can be altered.

For each ply or interply, the exported contour map and associated position and thickness data are integrated in step 56. Simulating non-destructive inspection requires a binary representation of damage. That is, material in a given pixel of the contour map is either damaged or undamaged. Accordingly, damage and defects from all indicators in the integrated data must be aggregated and binarised. Accordingly, aggregation rules must be applied to the data in step 58 to determine an aggregate damage and defect value $DD_{avg}$ from n sources of defect and damage information according to one of the equations 9-11:

$$\text{(equation 9)} \ DD_{avg} = (DD_1 + DD_2 + \ldots + DD_n)/n$$

$$\text{(equation 10)} \ DD_{avg} = w_1DD_1 + w_2DD_2 + \ldots + w_nDD_n)/n, \text{ where } w_1, w_2, \ldots, w_n$$

are predetermined weighting factors

$$\text{(equation 11)} \qquad DD_{avg} = \max(w_1DD_1, w_2DD_2, \ldots, w_nDD_n) \text{, where } w_1, w_2, \ldots,$$

$w_n$ are predetermined weighting factors

As described above in equations 10 and 11, weighting factors are optionally applied with the aggregation rules in step 60. Thereafter, the calculated aggregate DDavg is binarised to arrive at a binary damage state DDbin, where DDbin = 0 if DDavg < 0.5 and DDbin = 1 if DDavg $\geq$ 0.5. Once the binary damage and defect data is calculated, the exported contour maps are complete and ready for stacking. The maps are organized in a stack in the thickness direction in step 62 according to the position and thickness data associated with each map to build a representation of the material or structure, including defects and damage.

For numerical stability, simulating ultrasound-based non-destructive inspection requires that the voxels used to form the contour maps have a fineness of one tenth of the ultrasound wavelength. For example, if the simulation uses an ultrasound frequency of 5 MHz, the wavelength of the soundwaves is approximately 0.6 mm, and thus the voxel dimensions should be approximately 0.06 × 0.06 × 0.06 mm. While wavelength/10 provides the minimum resolution required, higher resolutions may be used. Preferably, the voxel size can be set by the user.

Once the voxel size is selected, a voxel model can be generated based on the stacked contour maps. However, because the voxel size often does not match the resolution of the data in the contour maps, interpolation of data is performed at step 64 so that each voxel includes data from the contour maps. Data from contour maps can be interpolated multiple ways. A first preferred interpolation rule directly maps data from the contour maps to one or more corresponding voxels based on the position and thickness associated with the data.

In a second preferred interpolation rule, damage is applied only to interplies. For each voxel of the interply, the damage associated with that voxel is determined by selecting the largest from among DDavg values from one of equations 9-11 for the interply, the ply directly above the interply, and the ply directly below the interply. Alternatively, a weighted average of the DDavg values using predetermined weighting factors can be taken to determine the damage value associated with the voxel.

A third preferred interpolation rule applies damage only to the plies. For each voxel of the ply, the damage associated with that voxel is determined by selecting the largest from among DDavg values from one of equations 9-11 for the ply, the interply directly above the ply, and the interply directly below the ply. Alternatively, a weighted average of the DDavg values using predetermined weighting factors can be taken to determine the damage value associated with the voxel.

Using this voxel model, existing non-destructive inspection simulation techniques can be performed in step 66. Known simulation techniques allow for, among other things, conducting virtual tests, designing new test methods, demonstrating performance, and designing new translators or probes.

While specific embodiments of the present invention have been shown and described, it should be understood that other modifications, substitutions and alternatives are apparent to one of ordinary skill in the art. Such modifications, substitutions and alternatives can be made without departing from the spirit and scope of the invention, which should be determined from the appended claims.

**Claims**

1. A method (10) for coupling non-destructive inspection data for a material or structure to an analysis tool, **characterized in that** the method comprises the following steps :

    receiving a voxel data (34,36) representation of a damaged area of the material or structure;
    generating a finite element mesh (20) based on said voxel data representation, said finite element mesh including a plurality of nodes, each said node corresponding to one or more voxels of said voxel data representation;

integrating damage information from said voxel data representation into said finite element mesh by applying at least one integration rule (22), said damage information indicating whether or not a given voxel has sustained damage;

interpolating damage information for areas of said finite element mesh that do not include damage information by applying at least one interpolation rule (26);

outputting a finite element model (28) including a finite element mesh having damage information (34) associated therewith.

2. The method (10) of claim 1, **characterized in that** the method further comprises a step (24) of applying predefined weighting factors to said damage information (34).

3. The method (10) of claim 1, **characterized in that** applying said at least one integration rule (22) comprises dividing said representation into one or more plies (37) and one or more interplies (38), said plies (37) and said interplies (38) being disposed alternately; and

for each node of said finite element mesh, determining whether said node includes damage, wherein it is determined that said node includes damage when damage information (34) of a corresponding voxel of said voxel data representation indicates that said voxel is damaged.

4. The method (10) of claim 3, **characterized in that** for each node that is determined to include damage, said node is disconnected from any adjacent nodes.

5. The method (10) of claim 1, **characterized in that** applying said at least one interpolation rule (26) comprises:

selecting a contour that surrounds a subset of voxels corresponding to a portion of the voxel representation, said subset of voxels including all damaged voxels in said portion of the voxel representation;

setting damage information (34) for each voxel within a perimeter of said contour such that each voxel within said perimeter is marked as damaged.

6. The method of claim 1, **characterized in that** it is executed by code stored on a non-transient medium in a computer that receives said voxel data and outputs said finite element model.

7. The method of claim 6, **characterized in that** said voxel data comprises data obtained from a non destructive inspection of an airplane material or structure.

8. A method (40) for coupling damage simulation for material or structure data to a non-destructive inspection simulation tool, **characterized in that** the method comprises the following steps:

receiving simulation data (46) related to an event which caused damage to the material or structure including one or more damage indicators;

generating one or more contour maps (50, 52) corresponding to areas of the material or structure;

aggregating said simulation data with said one or more contour maps by applying at least one aggregation rule (58) to said one or more contour maps;

interpolating said contour maps after said aggregating by applying one or more interpolation rules (64);

outputting a voxel model of the structure including the damaged area based on said interpolated contour maps.

9. The method of claim 8, **characterized in that** applying said aggregation rule (58) comprises, for each pixel contained in one of said one or more contour maps:

determining an average (9, 10, 11) of all damage indicators for the pixel; and

setting damage value for said pixel by binarising said determined average, such that if said average is less than 0.5, said damage value is set to be 0, and if said determined average is greater than or equal to 0.5, said damage value is set to 1.

10. The method of claim 9, **characterized in that** said average is an arithmetic mean.

11. The method of claim 10, **characterized in that** the method further comprises a step of applying predefined weighting factors (60) to said damage indicators.

12. The method of claim 8, **characterized in that** applying the said one or more interpolation rules (64) comprises the following steps:

   selecting a voxel size based on a wavelength used by the non-destructive inspection simulation tool;
   creating a portion of a voxel model, wherein said voxels are sized according to the selected voxel size; and
   mapping data from said contour maps to said portion of said voxel model.

13. The method of claim 8, **characterized in that** the method is executed by code stored on a non-transient medium in a computer that receives said simulation data and outputs said voxel model.

14. The method of claim 13, **characterized in that** said simulation data comprises data simulating stress applied to an airplane material or structure.

Fig. 1

Fig. 2

Fig. 3

Fig. 4A

Fig. 4B

Fig. 5B

Fig. 5A

Fig. 6

EP 2 829 994 A2

Fig. 7